# EUROPEAN PATENT APPLICATION

(11) **EP 4 510 171 A1**
(43) Date of publication of application: **19.02.2025**
(21) Application number: 23788243.6
(22) Date of filing: 05.04.2023
(51) Int. Cl.: H01L 21/304

(54) **SURFACE TREATMENT COMPOSITION AND METHOD FOR PRODUCING WAFER**

(30) Priority: 11.04.2022 JP 2022065098; 12.08.2022 JP 2022128657
(71) Applicant: Central Glass Company, Limited, Ube-shi, Yamaguchi 755-0001 (JP)
(72) Inventor: OKUMURA, Yuzo, Tokyo 101-0054 (JP); TERUI, Yoshiharu, Tokyo 101-0054 (JP); YOSHIDA, Ayaka, Tokyo 101-0054 (JP)
(74) Representative: Mewburn Ellis LLP
(86) International application number: PCT/JP2023/014102
(87) International publication number: WO 2023/199824

(57) **Abstract**

The present invention is a surface treatment composition which is supplied as vapor to the surface of a wafer having an uneven pattern on the surface and is used for forming a water-repellent protective film on the surface, the surface treatment composition including a silylating agent and a solvent, in which the silylating agent includes a silicon compound represented by (R¹)₃Si-X (R¹'s are each independently a group selected from the group consisting of a hydrocarbon group having 1 to 10 carbon atoms and a hydrocarbon group having 1 to 10 carbon atoms in which some or all hydrogen atoms are substituted with fluorine atoms, and X is an amino group), and in which the solvent includes 75% by mass or more of a hydrocarbon solvent in 100% by mass of the total amount of the solvent.

## Description

### TECHNICAL FIELD

The present invention relates to a surface treatment composition and a method for producing a wafer.

### BACKGROUND ART

For semiconductor devices for networks and digital home appliances, there is a demand for even higher performance, higher functionality, and lower power consumption. For this reason, the miniaturization of circuit patterns is progressing and, as miniaturization progresses, pattern collapse of the circuit patterns has become a problem. In semiconductor device production, cleaning steps are frequently used to remove particles and metal impurities and, as a result, cleaning steps account for 30 to 40% of all of the semiconductor production steps. In such cleaning steps, when the aspect ratio of a pattern increases along with miniaturization of the semiconductor device, the pattern collapses when a gas-liquid interface passes through the pattern after cleaning or rinsing. This phenomenon is pattern collapse. To prevent the occurrence of pattern collapse, there is no other option but to change the design of the patterns, which also leads to decreases in yield during production, thus, a method for preventing pattern collapse during the cleaning step is desired.

Forming a water-repellent protective film on the pattern surface is known to be effective as a method for preventing pattern collapse. The water repelling property needs to be imparted without drying the pattern surface, thus, a water-repellent protective film is formed by supplying a chemical solution for forming a water-repellent protective film, which is capable of making a pattern surface water repellent, to the pattern surface in a state where a cleaning liquid or the like is being held thereon, in order to replace the cleaning liquid or the like with the above-described chemical solution.

As this type of technique, the technique described in Patent Document 1 is known. Patent Document 1 describes a surface treatment composition including a silylating agent as well as diethyl carbonate and propylene carbonate as solvents (Example 5 of Patent Document 1).

### RELATED DOCUMENT

### PATENT DOCUMENT

[Patent Document 1] International Publication No. 2019/193967

### SUMMARY OF THE INVENTION

### TECHNICAL PROBLEM

However, as a result of studies by the present inventors, it was found that there is room for improvement in the surface treatment composition described in Patent Document 1 above in terms of the ease of increasing the water contact angle.

### SOLUTION TO PROBLEM

After further studies, the present inventors found that the above-described surface treatment composition easily increases the water contact angle as a result of using a silicon compound such as trialkylsilylamine as a silylating agent together with a hydrocarbon solvent having a content of 97% by mass or more in a solvent as the solvent and, through subsequent studies, further found that it is possible to maintain a contact angle that is high in practice as long as the content of the hydrocarbon solvent in the solvent is 75% by mass or more, thereby completing the present invention.

According to one aspect of the present invention, the surface treatment composition and method for producing a wafer described below are provided.

1. A surface treatment composition which is supplied as vapor to a surface of a wafer having an uneven pattern on the surface and is used for forming a water-repellent protective film on the surface, the surface treatment composition including a silylating agent, and a solvent, in which the silylating agent includes a silicon compound represented by Formula (1),

   (R¹)₃Si-X (1)

   (R¹'s are each independently a group selected from the group consisting of a hydrocarbon group having 1 to 10 carbon atoms and a hydrocarbon group having 1 to 10 carbon atoms in which some or all hydrogen atoms are substituted with fluorine atoms, and X is an amino group), and in which the solvent includes 75% by mass or more of a hydrocarbon solvent in 100% by mass of a total amount of the solvent.
2. The surface treatment composition according to 1., in which a content of the hydrocarbon solvent is 97% by mass or more in 100% by mass of the total amount of the solvent.
3. The surface treatment composition according to 1. or 2., in which the hydrocarbon solvent includes an aromatic hydrocarbon.
4. The surface treatment composition according to any one of 1. to 3., in which a content of the silylating agent in 100% by mass of the surface treatment composition is 0.3% by mass or more and 30% by mass or less.
5. The surface treatment composition according to any one of 1. to 4., in which a boiling point difference between a boiling point of the solvent and a boiling point of the silylating agent (boiling point of the solvent - boiling point of the silylating agent) at 1 atm is 20°C or more.
6. The surface treatment composition according to any one of 1. to 5., in which the silicon compound includes one or two or more selected from the group consisting of trimethylsilyldimethylamine, trimethylsilyldiethylamine, N-(trimethylsilyl)-tert-butylamine, hexamethyldisilazane, and compounds in which at least one trimethylsilyl group of these trimethylsilylamines is substituted with any of an ethyldimethylsilyl group, a propyldimethylsilyl group, a butyldimethylsilyl group, a hexyldimethylsilyl group, an octyldimethylsilyl group, and a decyldimethylsilyl group.
7. The surface treatment composition according to any one of 1. to 6., in which a water contact angle on a surface of a silicon wafer after surface treatment is greater than 80°, as measured by a procedure as below,
   (procedure)
   a smooth silicon wafer having a thermal oxide film layer on a surface is immersed in a 1% by mass hydrofluoric acid aqueous solution at 25°C for 10 minutes and immersed and cleaned in pure water at 25°C for 1 minute and 2-propanol (iPA) at 25°C for 1 minute,
   after cleaning, the silicon wafer is arranged horizontally in a state of being filled to the brim with iPA and vapor of the surface treatment composition is supplied to the silicon wafer,
   subsequently, on the surface of the silicon wafer, the vapor is changed into a liquid state and the iPA held on the surface is replaced with the liquid,
   subsequently, the silicon wafer is immersed in iPA at 25°C for 1 minute,
   thereafter, air is blown onto the silicon wafer to remove the iPA on the surface, and
   with respect to the silicon wafer surface obtained through the above steps, the water contact angle described above is measured in accordance with "Wettability test method for substrate glass surface" of JIS R 3257:1999 using 2 µl of pure water.
8. The surface treatment composition according to any one of 1. to 7., in which the surface treatment composition does not include a non-cyclic carbonate ester or includes 2% by mass or less of a non-cyclic carbonate ester in 100% by mass of the surface treatment composition.
9. The surface treatment composition according to any one of 1. to 8., in which the surface treatment composition does not include a catalyst or includes a catalyst in a content of 2% by mass or less in 100% by mass of the surface treatment composition.
10. The surface treatment composition according to any one of 1. to 9., in which a number of particles larger than 0.2 µm measured using a light-scattering particle-in-liquid detector is 1.0 × 10⁴ or less per 1 mL of the surface treatment composition.
11. The surface treatment composition according to any one of 1. to 10., in which a total content of Na, Mg, Ca, Mn, Fe, Cu, Li, Al, Cr, Ni, Zn, and Ag measured using inductively coupled plasma mass spectrometry is 100 mass ppb or less in the surface treatment composition.
12. A method for producing a wafer including a step of preparing a wafer having an uneven pattern on a surface, a step of supplying a cleaning liquid to the surface of the wafer to carry out cleaning, and a step of supplying vapor of a surface treatment composition to the surface holding the cleaning liquid, changing the state of the vapor to a liquid on the surface, replacing the cleaning liquid with the liquid, and forming a water-repellent protective film on at least a part of the surface, in which the surface treatment composition includes a silylating agent, and a solvent, in which the silylating agent includes a silicon compound represented by Formula (1),

   (R¹)₃Si-X (1)

   (R¹'s are each independently a group selected from the group consisting of a hydrocarbon group having 1 to 10 carbon atoms and a hydrocarbon group having 1 to 10 carbon atoms in which some or all hydrogen atoms are substituted with fluorine atoms, and X is an amino group), and in which the solvent includes 75% by mass or more of a hydrocarbon solvent in 100% by mass of a total amount of the solvent.
13. The method for producing a wafer according to 12., in which a content of the hydrocarbon solvent is 97% by mass or more in 100% by mass of the total amount of the solvent.
14. The method for producing a wafer according to 12. or 13., in which, in the surface treatment composition, the hydrocarbon solvent includes an aromatic hydrocarbon.
15. The method for producing a wafer according to any one of 12. to 14., in which, in the surface treatment composition, a content of the silylating agent is 0.3% by mass or more and 30% by mass or less in 100% by mass of the surface treatment composition.
16. The method for producing a wafer according to any one of 12. to 15., in which, in the surface treatment composition, a boiling point difference between a boiling point of the solvent and a boiling point of the silylating agent (boiling point of the solvent - boiling point of the silylating agent) at 1 atm is 20°C or more.
17. The method for producing a wafer according to any one of 12. to 16., in which, in the surface treatment composition, the silicon compound includes one or two or more selected from the group consisting of trimethylsilyldimethylamine, trimethylsilyldiethylamine, N-(trimethylsilyl)-tert-butylamine, hexamethyldisilazane, and compounds in which at least one trimethylsilyl group of these trimethylsilylamines is substituted with any of an ethyldimethylsilyl group, a propyldimethylsilyl group, a butyldimethylsilyl group, a hexyldimethylsilyl group, an octyldimethylsilyl group, and a decyldimethylsilyl group.
18. The method for producing a wafer according to any one of 12. to 17., in which the surface treatment composition does not include a non-cyclic carbonate ester or includes 2% by mass or less of a non-cyclic carbonate ester in 100% by mass of the surface treatment composition.
19. The method for producing a wafer according to any one of 12. to 18., in which the surface treatment composition does not include a catalyst or includes a catalyst in a content of 2% by mass or less in 100% by mass of the surface treatment composition.
20. The method for producing a wafer according to any one of 12. to 19., in which, in the surface treatment composition, a number of particles larger than 0.2 µm measured using a light-scattering particle-in-liquid detector is 1.0 × 10⁴ or less per 1 mL of the surface treatment composition.
21. The method for producing a wafer according to any one of 12. to 20., in which, in the surface treatment composition, a total content of Na, Mg, Ca, Mn, Fe, Cu, Li, Al, Cr, Ni, Zn, and Ag measured using inductively coupled plasma mass spectrometry is 100 mass ppb or less in the surface treatment composition.
22. The method for producing a wafer according to any one of 12. to 21., in which the vapor of the surface treatment composition is supplied in a state where iPA is held on the surface of the wafer.
23. The method for producing a wafer according to any one of 12. to 22., further including a step of mixing materials of each component of the surface treatment composition, in which a total amount of moisture in the materials is 2000 ppm by mass or less with respect to a total amount of the materials.

### ADVANTAGEOUS EFFECTS OF INVENTION

According to the present invention, a surface treatment composition that easily increases a water contact angle and a method for producing a wafer using the same are provided.

### BRIEF DESCRIPTION OF THE DRAWINGS

Fig. 1 is a schematic perspective view of a wafer for which a surface has a fine uneven pattern.
Fig. 2 is a schematic cross-sectional view showing a part of an a-a' cross-section in Fig. 1.
Fig. 3 is a schematic cross-sectional view showing a state in which vapor of a composition is supplied to concave portions holding a liquid.
Fig. 4 is a schematic cross-sectional view of a wafer on which a water-repellent protective film is formed.

### DESCRIPTION OF EMBODIMENTS

An explanation will be given below of embodiments of the present invention using the drawings. In all the drawings, the same constituent elements are denoted by the same reference numerals and explanations thereof will not be repeated, as appropriate. In addition, the figures are schematic views and do not correspond to the actual dimensional ratios.

An explanation will be given of a summary of the surface treatment composition of the present embodiment.

The surface treatment composition of the present embodiment is supplied as vapor to a surface of a wafer having an uneven pattern on the surface and is used for forming a water-repellent protective film on the surface.

This surface treatment composition includes a silylating agent and a solvent and is formed such that the silylating agent includes a silicon compound represented by Formula (1) and the solvent includes 75% by mass or more of a hydrocarbon solvent in 100% by mass of the total amount of the solvent.

(R¹)₃Si-X (1)

(R¹'s are each independently a group selected from the group consisting of a hydrocarbon group having 1 to 10 carbon atoms and a hydrocarbon group having 1 to 10 carbon atoms in which some or all hydrogen atoms are substituted with fluorine atoms, and X is an amino group)

By using and applying the surface treatment composition of the present embodiment in the production of wafers having an uneven pattern on the surface, it is possible to suppress pattern collapse of the uneven pattern.

Here, an explanation will be given of the production of a semiconductor wafer as an example.

In the semiconductor wafer production process, a fine uneven pattern is formed on a substrate (wafer) surface through film formation, lithography, etching, or the like and then a wet-type treatment such as a cleaning step using water or an organic solvent is performed to clean the wafer surface and a drying step is also performed to remove liquid such as a cleaning liquid or a rinsing liquid attached to the wafer due to the wet-type treatment.

During such a drying step, deformation or collapse of the uneven pattern is known to easily occur in wafers having a fine uneven pattern.

By forming a water-repellent protective film on the uneven pattern using the vapor of the surface treatment composition and modifying the surface such that the wafer surface exhibits water-repellency, it is possible to suppress the deformation and collapse of the uneven pattern during the drying step. This makes it possible to realize a method for producing a wafer having excellent production stability.

According to the findings of the present inventors, it was found that the surface treatment composition easily increased the water contact angle as a result of including the predetermined silicon compound as a silylating agent and also using a hydrocarbon solvent having a content of 97% by mass or more in the solvent as a solvent. Furthermore, it was found that it is possible to maintain a contact angle that is high in practice by also using a hydrocarbon solvent for which the content in the solvent is increased to 75% by mass or more. From the viewpoint of improving the throughput of the production process, it is preferable to use methods that more easily increase the water contact angle even in a shorter time.

Although the detailed mechanism is not clear, by using a hydrocarbon, which is a solvent that does not easily react with the predetermined silicon compound of the silylating agent, as the main component of the solvent, it is possible to suppress the reaction in the liquid and improve the storage stability and the reaction in gas (vapor) is also suppressed, thus, the surface treatment composition is considered to easily increase the water contact angle.

In addition, since a solvent with a high boiling point (low volatility) preferentially aggregates on the wafer surface and the replacement of the cleaning liquid therewith proceeds, it is possible to suppress the silylating agent from reacting with the cleaning liquid and being consumed, thus, it is considered that it is possible to easily increase the water contact angle.

A detailed description will be given below of the configuration of the surface treatment composition of the present embodiment.

### (Silylating Agent)

The surface treatment composition includes one or two or more of the silicon compounds represented by Formula (1) as a silylating agent (the silicon compound represented by Formula (1) may also be simply referred to below as a silicon compound).

It is noted that the silylating agent may include only the silicon compound of Formula (1) or may include a silylating agent other than the silicon compound of Formula (1) as long as the effects of the present invention are not impaired.

(R¹)₃Si-X (1)

(R¹'s are each independently a group selected from the group consisting of a hydrocarbon group having 1 to 10 carbon atoms and a hydrocarbon group having 1 to 10 carbon atoms in which some or all hydrogen atoms are substituted with fluorine atoms, and X is an amino group)

Examples of the amino group include monovalent groups obtained by removing hydrogen from ammonia, primary amines, or secondary amines, for example, -NH₂, a dialkylamino group (-N(CH₃)₂, -N(C₂H₅)₂, and the like), a t-butylamino group, an allylamino group, -NHSi(CH₃)₃, -NH-C(=O)-Si(CH₃)₃, -NHC(=O)CH₃, - NHC(=O)CF₃, -N(CH₃)C(=O)CH₃, -N(CH₃)C(=O) CF₃, -NHC(=O)-OSi(CH₃)₃, - NHC(=O)-NH-Si(CH₃)₃ (for example, N,N'-bis(trimethylsilyl)urea, and the like), a group having a nitrogen-including ring (the nitrogen atom forming the ring bonds to the Si atom described above), and the like may be used. Examples of the nitrogen-including rings described above include piperidine rings, imidazole rings (for example, N-trimethylsilylimidazole, and the like), triazole rings (for example, N-trimethylsilyltriazole, and the like), tetrazole rings, oxazolidinone rings, morpholine rings, other nitrogen-containing heterocyclic rings, and the like. From the viewpoint of further increasing the water contact angle, the amino group is preferably a dialkylamino group, more preferably a dialkylamino group in which the alkyl group has 1 to 4 carbon atoms, and even more preferably a dimethylamino group (-N(CH₃)₂).

From the viewpoint of further increasing the water contact angle, R¹'s preferably each independently include a hydrocarbon group having 1 to 10 carbon atoms, more preferably include a hydrocarbon group having 1 to 6 carbon atoms, and even more preferably include a hydrocarbon group having 1 to 4 carbon atoms.

In addition, from the viewpoint of further increasing the water contact angle, at least one R¹ preferably includes a hydrocarbon group having 3 to 4 carbon atoms and more preferably includes a propyl group or a butyl group.

The silicon compound is a silane compound having at least a structure in which three groups represented by R¹ described above and one amino group are bonded to one Si atom in one molecule. Specific examples thereof include trimethylsilylamines such as trimethylsilyldimethylamine, trimethylsilyldiethylamine, N-(trimethylsilyl)-tert-butylamine, hexamethyldisilazane, trimethylsilylpiperidine, and N-(trimethylsilyl)-imidazole; compounds in which at least one trimethylsilyl group of the trimethylsilylamines described above is substituted with any of an ethyldimethylsilyl group, a propyldimethylsilyl group, a butyldimethylsilyl group, a hexyldimethylsilyl group, an octyldimethylsilyl group, or a decyldimethylsilyl group (specifically, ethyldimethylsilyldimethylamine, propyldimethylsilyldimethylamine, butyldimethylsilyldimethylamine, hexyldimethylsilyldimethylamine, octyldimethylsilyldimethylamine, decyldimethylsilyldimethylamine, and the like). The above may be used alone or in a combination of two or more.

Among the above, from the viewpoint of resistance to deactivation of the silylating agent when vaporized (vapor stability), at least one kind selected from the group consisting of trimethylsilyldimethylamine, trimethylsilyldiethylamine, N-(trimethylsilyl)-tert-butylamine, hexamethyldisilazane, compounds in which at least one trimethyl silyl group of the above trimethylsilylamines (trimethylsilyldimethylamine, trimethylsilyldiethylamine, N-(trimethylsilyl)-tert-butylamine, and hexamethyldisilazane) is an ethyldimethylsilyl group, compounds in which the group is a propyldimethylsilyl group, compounds in which the group is a butyldimethylsilyl group, compounds in which the group is a hexyldimethylsilyl group, compounds in which the group is a octyldimethylsilyl group, and compounds in which the group is a decyldimethylsilyl group (specifically, ethyldimethylsilyldimethylamine, propyldimethylsilyldimethylamine, butyldimethylsilyldimethylamine, hexyldimethylsilyldimethylamine, octyldimethylsilyldimethylamine, decyldimethylsilyldimethylamine, or the like) is preferable.

In addition, from the viewpoint of silylation reactivity, at least one kind selected from the group consisting of trimethylsilyldimethylamine, trimethylsilyldiethylamine, and N-(trimethylsilyl)-tert-butylamine is more preferable.

In addition, from the viewpoint of further increasing the water contact angle, at least one kind selected from the group consisting of trimethylsilyldimethylamine, propyldimethylsilyldimethylamine, and butyldimethylsilyldimethylamine is preferable.

The lower limit of the content of the silylating agent in 100% by mass of the surface treatment composition is, for example, 0.3% by mass or more, preferably 1% by mass or more, and more preferably 2% by mass or more. Due to this, the surface treatment composition easily increases the water contact angle.

On the other hand, the upper limit of the content of the silylating agent in 100% by mass of the surface treatment composition is, for example, 30% by mass or less, preferably 25% by mass or less, more preferably 20% by mass or less, and even more preferably 15% by mass or less. This makes it possible to improve the storage stability.

The lower limit of the content of the silicon compound in 100% by mass of the silylating agent is, for example, 50% by mass or more, preferably 70% by mass or more, more preferably 80% by mass or more, even more preferably 90% by mass or more, and still more preferably 95% by mass or more. Due to this, the surface treatment composition easily increases the water contact angle.

On the other hand, the upper limit of the content of the silicon compound in 100% by mass of the silylating agent is not particularly limited, but may be 100% by mass or less, or 98% by mass or less in the case of using a plurality of silylating agents together.

### (Solvent)

The surface treatment composition includes one or two or more hydrocarbon solvents as a solvent.

Examples of the hydrocarbon solvent include hydrocarbons having 5 to 24 carbon atoms that are liquid at 1 atm, which may be hydrocarbons having not only a linear structure, but also a branched structure or a cyclic structure. In addition, the included hydrocarbons may have a double bond, and some of the hydrogen atoms may be substituted with halogen atoms.

Specific examples of hydrocarbon solvents include linear saturated aliphatic hydrocarbons such as n-hexane, n-heptane, n-octane, n-nonane, n-decane, n-undecane, n-dodecane, n-tridecane, n-tetradecane, n-hexadecane, n-octadecane, and n-eicosane, as well as branched saturated aliphatic hydrocarbons corresponding to these carbon atom numbers, alicyclic hydrocarbons such as cyclohexane, methylcyclohexane, ethylcyclohexane, propylcyclohexane, isopropylcyclohexane, butylcyclohexane, amylcyclohexane, 1,1,3-trimethylcyclohexane, 1,1,4-trimethylcyclohexane, 1,2,3-trimethylcyclohexane, 1,2,4-trimethylcyclohexane, 1,3,5-trimethylcyclohexane, and decalin, cyclic hydrocarbons such as menthane (o-, m-, or p-), diphenylmenthane, limonene, terpinene (α-, β-, or γ-), bornane, norbornane, pinane, pinene (α-, or β-), calan, and longifolene, aromatic hydrocarbons such as benzene, allylbenzene, toluene, styrene, xylene (o-, m-, or p-), ethylbenzene, 1,2-diethylbenzene, 1,3-diethylbenzene, 1,4-diethylbenzene, 1,2,3-trimethylbenzene, 1,2,4-trimethylbenzene, 1,3,5-trimethylbenzene, n-butylbenzene, isobutylbenzene, and tert-butylbenzene, halogenated hydrocarbons such as 1,3-bis(trifluoromethyl)benzene, 1,4-bis(trifluoromethyl)benzene, and the like. The above may be used alone or in a combination of two or more.

Among the above, from the viewpoint of the ease of increasing the water contact angle, as the hydrocarbon solvent, at least one kind selected from the group consisting of 1,2,4-trimethylbenzene, 1,3,5-trimethylbenzene, tert-butylbenzene, ethylbenzene, 1,3-bis(trifluoromethyl)benzene, 1,4-bis(trifluoromethyl)benzene, p-xylene, n-nonane, and isododecane is preferable, and at least one kind selected from the group consisting of 1,2,4-trimethylbenzene, 1,3,5-trimethylbenzene, tert-butylbenzene, ethylbenzene, 1,3-bis(trifluoromethyl)benzene, 1,4-bis(trifluoromethyl)benzene, and p-xylene is more preferable.

As described below in the Examples and the like, the ease of increasing the water contact angle was evaluated using an average value obtained by measuring the water contact angle at five points on a sample obtained by, in a state where a silicon wafer surface to which a smooth thermal oxide film is attached is filled to the brim with iPA, supplying the vapor of the surface treatment composition thereto for 40 seconds, carrying out cleaning using iPA, and carrying out drying under predetermined conditions.

In addition, from the viewpoint of easily suppressing variations in the water contact angle, the hydrocarbon solvent preferably includes an aromatic hydrocarbon. Among aromatic hydrocarbons, it is more preferable to include at least one kind selected from the group consisting of 1,2,4-trimethylbenzene, 1,3,5-trimethylbenzene, tert-butylbenzene, ethylbenzene, 1,3-bis(trifluoromethyl)benzene, 1,4-bis(trifluoromethyl)benzene, and p-xylene.

The variation in the water contact angle was evaluated using the standard deviation calculated from the measurement results of the water contact angle at the five points on the sample described above.

The solvent includes 75% by mass or more of a hydrocarbon solvent in 100% by mass of the total amount of the solvent, preferably 80% by mass or more, more preferably 85% by mass or more, even more preferably 90% by mass or more, still more preferably 97% by mass or more, and yet more preferably 99% by mass or more. Due to this, the surface treatment composition easily increases the water contact angle. By setting the content of the hydrocarbon solvent in the solvent to 97% by mass or more and also using the preferable types of hydrocarbon solvents described above, it is possible to suppress variations in the water contact angle while realizing a higher water contact angle.

In addition, the solvent may also substantially consist only of a hydrocarbon solvent. Furthermore, the content of the hydrocarbon solvent may be 100% by mass. In such a case, the inclusion of undetectable levels of other solvents is allowed.

The solvent may contain other solvents than the hydrocarbon solvents described above, as long as 25% by mass or less in 100% by mass of the total amount of the solvent, preferably 20% by mass or less, more preferably 15% by mass or less, even more preferably 10% by mass or less, still more preferably 5% by mass or less, yet more preferably 3% by mass or less, and yet more preferably 1% by mass or less. The other solvents are preferably aprotic solvents, for example, esters, ketones, halogen-containing solvents (excluding halogenated hydrocarbons in which at least some of the hydrogen atoms in the hydrocarbon solvent are substituted with halogen atoms such as fluorine atoms), derivatives of polyhydric alcohols having no OH group, and the like may be used, and propylene glycol monoethyl ether acetate (PGMEA) is preferably used.

### (Surface Treatment Composition)

As an example of the present embodiment, the total content of the silicon compound and the hydrocarbon solvent in 100% by mass of the surface treatment composition is, for example, 60% by mass or more, preferably 80% by mass or more, and more preferably 95% by mass or more. Due to this, the water contact angle is easily increased.

In addition, the surface treatment composition may consist only of a silylating agent and a hydrocarbon solvent and preferably consists only of the silicon compound and a hydrocarbon solvent.

In addition, in the surface treatment composition, a boiling point difference between the boiling point of the solvent and the boiling point of the silylating agent (boiling point of the solvent - boiling point of the silylating agent) at 1 atm is, for example, 10°C or more, preferably 20°C or more, more preferably 30°C or more, even more preferably 40°C or more, still more preferably 50°C or more, and yet more preferably 55°C or more. Due to this, the solvent having a high boiling point preferentially aggregates on the wafer surface and the replacement of the cleaning liquid therewith proceeds, thus, the deactivation of the silylating agent due to contact with the cleaning liquid is suppressed and, as a result, the surface treatment composition easily increases the water contact angle. In addition, the boiling point of the solvent may be any as long as the silylating agent is not thermally decomposed during vaporization and the boiling point difference is not particularly limited. For example, the boiling point difference may be 200°C or lower, 180°C or lower, 150°C or lower, 130°C or lower, or 110°C or lower.

For the boiling point of solvents and silylating agents for which a plurality of types are included, the boiling point of the component having the highest content (% by mass) among the components included in the solvents and silylating agents is adopted (however, the boiling point of the component with the highest temperature is adopted when two or more components with the highest content exist).

The surface treatment composition preferably has a low water content and particularly preferably substantially does not include water.

The surface treatment composition of the present embodiment can include other components than the components described above in a range in which the object of the present invention is not impaired. Examples of these other components include other silylating agents than the silicon compounds described above, solvents other than hydrocarbon solvents, surfactants, antioxidants such as BHT (dibutylhydroxytoluene), and the like.

The surface treatment composition may be formed such that the surface treatment composition does not include a non-cyclic carbonate ester or includes 2% by mass or less of a non-cyclic carbonate ester in 100% by mass of the surface treatment composition. By being in the above range, it is possible to improve storage stability. In addition, the surface treatment composition may substantially not include a non-cyclic carbonate ester. Here, "substantially not include" means to a degree at which the performance of the surface treatment composition is not influenced, which may be, for example, 1% by mass or less in the surface treatment composition.

The surface treatment composition may be formed such that the surface treatment composition does not include a catalyst or includes a catalyst in a content of 2% by mass or less in 100% by mass of the surface treatment composition. The catalyst promotes the reaction between the wafer surface and the silylating agent (the silicon compound described above). In addition, for the purpose of further improving the storage stability, the catalyst may be substantially not included. Here, "substantially not included" means to a degree at which the performance of the surface treatment composition is not influenced, which may be, for example, 1% by mass or less in the surface treatment composition.

Examples of catalysts include trimethylsilyltrifluoroacetate, trimethylsilyltrifluoromethanesulfonate, dimethylsilyltrifluoroacetate, dimethylsilyltrifluoromethanesulfonate, butyldimethylsilyltrifluoroacetate, butyldimethylsilyltrifluoromethanesulfonate, hexyldimethylsilyltrifluoroacetate, hexyldimethylsilyltrifluoromethanesulfonate, octyldimethylsilyltrifluoroacetate, octyldimethylsilyltrifluoromethanesulfonate, decyldimethylsilyltrifluoroacetate, decyldimethylsilyltrifluoromethanesulfonate, sulfonic acid, anhydrides of sulfonic acid, salts of sulfonic acid, sulfonic acid derivatives, sulfonic acid esters, sulfoneimides, sulfoneimide derivatives, sulfonemethides, sulfonemethide derivatives, acid imidates, nitrogen-containing heterocyclic compounds, and silylated heterocyclic compounds.

The surface treatment composition of the present embodiment is obtained by mixing each of the components described above.

The obtained mixed liquid may be purified using an adsorbent, a filter, or the like as necessary. In addition, each component may be purified in advance by distillation and also purified by using an adsorbent, a filter, or the like.

The surface treatment composition is formed such that the water contact angle on a surface of the silicon wafer after the surface treatment as measured by the following procedure is, for example, greater than 80°, preferably 81° or more, more preferably 83° or more, even more preferably 85° or more, still more preferably 87° or more, and yet more preferably 89° or more. The larger the water contact angle, the more easily the surface treatment composition increases the water contact angle.

### (Procedure)

A silicon wafer having a thermal oxide film layer on a surface is immersed in a 1% by mass hydrofluoric acid at 25°C for 10 minutes and immersed and cleaned in pure water at 25°C for 1 minute and 2-propanol (iPA) at 25°C for 1 minute.

After cleaning, the silicon wafer is arranged horizontally in a state of being filled to the brim with iPA and the vapor of the surface treatment composition is supplied to the silicon wafer.

Subsequently, on the surface of the silicon wafer, the vapor is changed into a liquid state and the iPA held on the surface is replaced with the liquid.

Subsequently, the silicon wafer is immersed in iPA at 25°C for 1 minute.

Thereafter, air is blown onto the silicon wafer to remove the iPA on the surface.

With respect to the silicon wafer surface obtained through the above steps, the water contact angle described above is measured in accordance with "Wettability test method for substrate glass surface" of JIS R 3257:1999 using 2 µl of pure water. Measurements are performed at five points on the silicon wafer sample described above and the average value thereof is adopted as the "water contact angle". In addition, the standard deviation calculated from the water contact angle measurement results at the five points described above is adopted as the "variation in water contact angle".

In the surface treatment composition, the number of particles larger than 0.2 µm measured using a light-scattering particle-in-liquid detector is, for example, 1.0 × 10⁴ or less per 1 mL of the surface treatment composition, preferably 1.0 × 10³ or less, and more preferably 1.0 × 10² or less. This makes it possible to suppress the risk that the inside of the vapor treatment apparatus, the vaporization chamber for vaporizing the surface treatment composition, other liquid feeding parts, and the like will be contaminated, resulting in a decrease in yield and in the reliability of the device.

On the other hand, while the number of particles larger than 0.2 µm is preferably as small as possible, there may be one or more particles per 1 mL of the composition while in the content range described above.

For the measurement of the particles in the surface treatment composition in the liquid phase, the measurement is carried out using a commercially available measuring device using a light-scattering particle-in-liquid measurement system using a laser as a light source and the diameter of the particles signifies the light scattering equivalent diameter based on polystyrene latex (PSL) standard particles.

"Particles" ultimately refers to undissolved particles present in the composition, which are particles such as dust, dirt, organic solids, and inorganic solids that are included as impurities in the materials of each component of the surface treatment composition, particles such as dust, dirt, organic solids, and inorganic solids that are introduced as contaminants during the preparation of the composition, or the like.

The surface treatment composition is formed such that the total content of Na, Mg, Ca, Mn, Fe, Cu, Li, Al, Cr, Ni, Zn, and Ag measured using inductively coupled plasma mass spectrometry is, for example, 100 mass ppb or less in the surface treatment composition, preferably 10 mass ppb or less, and more preferably 1 mass ppb or less. This makes it possible to suppress the risk that the inside of the vapor treatment apparatus will be contaminated, resulting in a decrease in yield and in the reliability of the device.

On the other hand, as long as the total content is in the range described above, each element may be 0.0001 mass ppb or more with respect to the total amount of the composition.

A description will be given below of a method for producing a wafer using the surface treatment composition.

The method for producing a wafer of the present embodiment includes a step of preparing a wafer having an uneven pattern on a surface, a step of supplying a cleaning liquid to the surface of the wafer to carry out cleaning, and a step of supplying the vapor of the surface treatment composition described above to the surface holding the cleaning liquid, changing the state of the vapor to a liquid on the surface, replacing the cleaning liquid with the liquid, and forming a water-repellent protective film on at least a part of the surface.

In addition to the above steps, one or two or more of a pre-rinsing (first rinsing) step, a post-rinsing (second rinsing) step, a drying step, a water-repellent protective film removal step, and the like may be performed.

It is possible to use the same surface treatment composition as described above as the surface treatment composition used in the method for producing a wafer of the present embodiment.

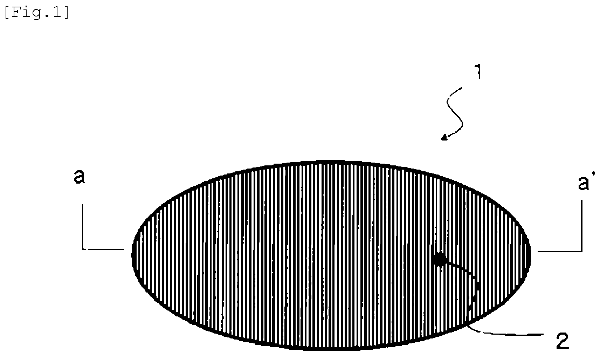

Figs. 1 to 4 show examples of wafer production steps using a surface treatment composition.

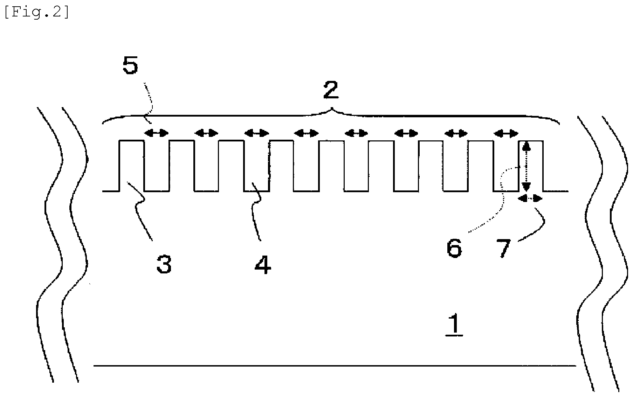

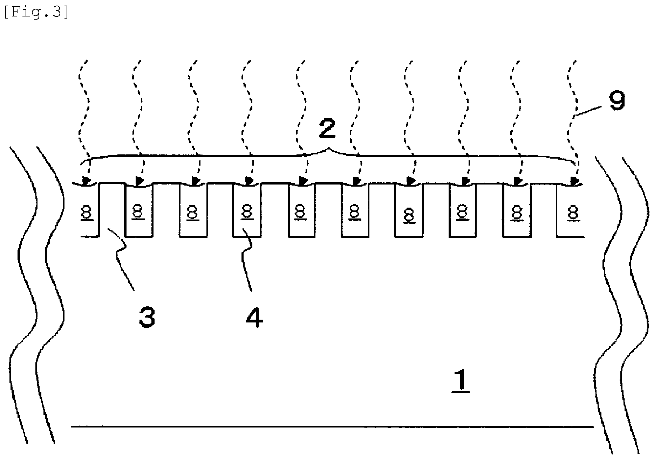

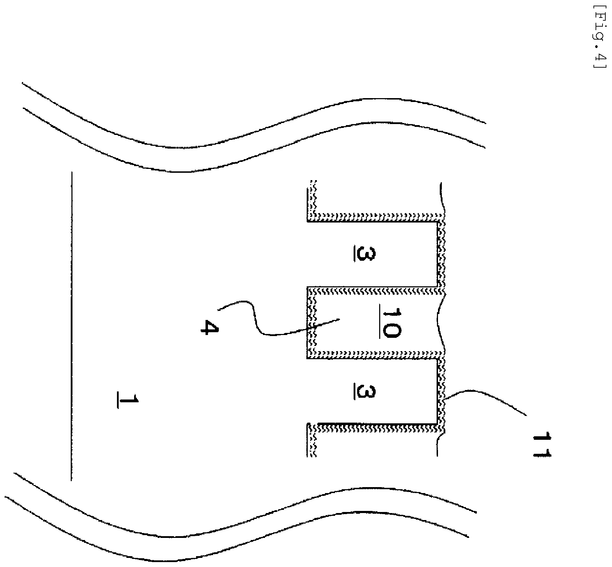

Fig. 1 is a schematic perspective view of a wafer 1 for which a surface has a fine uneven pattern 2. Fig. 2 is a schematic cross-sectional view of the wafer 1 showing a part of the a-a' cross-section in Fig. 1. Fig. 3 is a diagram showing a step of supplying a vapor 9 of the composition to concave portions 4 holding a liquid 8. Fig. 4 is a diagram showing a step of cleaning the concave portion 4, in which a water-repellent protective film 11 is formed by the composition, using a liquid 10.

First, the wafer 1 having an uneven pattern on the surface is prepared.

In the preparation step of the wafer 1, the following method, which is an example of a method for forming the uneven pattern 2 on the wafer surface, may be used.

First, after applying a resist to the wafer surface, the resist is exposed to light through a resist mask and either the exposed resist or the unexposed resist is removed to produce a resist having a desired uneven pattern. In addition, it is possible to obtain a resist having an uneven pattern by pressing a mold having a pattern against the resist. Next, the wafer is etched. At this time, the substrate surface corresponding to the concave portions of the resist pattern is selectively etched. Finally, when the resist is peeled off, the wafer 1 having the uneven pattern 2 on the surface is obtained.

The materials of the wafer on which the uneven pattern 2 is formed and the uneven pattern 2 are not particularly limited.

As the material of the wafer 1, it is possible to use various wafers such as silicon wafers, silicon carbide wafers, wafers composed of a plurality of components including a silicon element, sapphire wafers, and various compound semiconductor wafers.

The material of the uneven pattern 2 may include one or two or more selected from the group consisting of Si, Ti, Ge, W, and Ru, and oxides, nitrides, nitrogen oxides, carbonitrides, and carbide oxides including one or more of the above. For example, as the material of the uneven pattern 2, it is possible to use silicon-based materials such as silicon oxide, silicon nitride, polycrystalline silicon, single crystal silicon, and silicon germanium, metal-based materials such as titanium nitride, tungsten, ruthenium, tantalum nitride, and tin, various combinations of the above-described materials, resist (photoresist) materials, and the like.

For example, the uneven pattern 2 may be formed to have a three-dimensional structure having one or two or more structures arranged along an orthogonal direction to the surface, and/or one or two or more structures arranged along the horizontal direction perpendicular to the orthogonal direction. As an example of such a three-dimensional structure, at least a part of a logic device or a memory device may be formed and examples thereof include a FinFET, a nanowire FET, a nanosheet FET, or another multi-gate type FET, three-dimensional memory cells, and the like.

Fig. 2 is a cross-sectional view showing an example of the uneven pattern 2.

In the present embodiment, it is possible to define the pattern dimension of the uneven pattern 2 as at least one dimension in the width direction in the in-plane direction of the surface and/or at least one dimension in the height direction in the direction orthogonal to the surface.

In the cross-sectional structure (in the substrate thickness direction) in the pattern of the uneven pattern 2, at least one or more pattern dimension of the width and height or, in a three-dimensional structure (XYZ three-dimensional coordinates) in the pattern of the uneven pattern 2, at least one or more pattern dimension of the width (length in the X-axis direction), height (length in the Y-axis direction), and depth (length in the Z-axis direction) may be, for example, 30 nm or less, 20 nm or less, or 10 nm or less. The above may be the interval between patterns. Even when the wafer 1 having the fine uneven pattern 2 is used, it is possible to apply the surface treatment composition of the present embodiment.

Such a surface treatment composition is suitable for a surface treatment of, for example, the wafer 1 having the uneven pattern 2 having a pattern dimension of 30 nm or less, preferably 20 nm or less.

The aspect ratio of convex portions 3 may be, for example, 3 or more, 5 or more, or 10 or more. It is possible to suppress pattern collapse even in the uneven pattern 2 having the convex portions 3 having a fragile structure.

On the other hand, the aspect ratio of the convex portions 3 is not particularly limited, but may be 100 or less.

The aspect ratio of the convex portions 3 is expressed as the value obtained by dividing a height 6 of the convex portions by a width 7 of the convex portions.

In addition, a width 5 of the concave portions may be, for example, 70 nm or less, preferably 45 nm or less.

The width 5 of the concave portions is indicated by the interval between adjacent convex portions 3 in the cross-sectional view of Fig. 2.

Next, the surface of the wafer 1 is cleaned with a cleaning liquid.

In the cleaning step, the surface of the wafer 1 may be brought into contact with an aqueous cleaning solution that is one of the cleaning liquids.

Examples of aqueous cleaning solutions include water, alcohol, ammonium hydroxide aqueous solutions, tetramethylammonium aqueous solutions, hydrofluoric acid aqueous solutions, hydrochloric acid aqueous solutions, hydrogen peroxide aqueous solutions, sulfuric acid aqueous solutions, organic solvents, and the like. The above may be used alone or in a combination of two or more.

The cleaning step may be performed once or twice or more before the surface treatment step or before the first rinsing step described below. Other steps may be included between the plurality of cleaning steps or between the cleaning step and the surface treatment step.

Subsequently, as necessary, the surface of the wafer 1 may be brought into contact with a first rinsing solution, which is one of the cleaning liquids (first rinsing step).

As the first rinsing solution, it is possible to use a cleaning liquid different from the aqueous cleaning solution and examples thereof include water, an organic solvent, a mixture thereof, or a cleaning liquid mixed thereof with at least one of an acid, an alkali, a surfactant, and an oxidizing agent, or the like.

Examples of the organic solvent used in the first rinsing solution include hydrocarbons, esters, ethers, ketones, halogen element-containing solvents, sulfoxide-based solvents, alcohols, polyhydric alcohol derivatives, nitrogen element-containing solvents, and the like. Among the above, as the organic solvent, it is preferable to use at least one type of alcohol selected from alcohols having 3 or less carbon atoms, such as methanol, 1-propanol, and 2-propanol (isopropanol).

In addition, a plurality of types may be used as the first rinsing solution. For example, it is possible to perform the rinsing in the order of a solution including an acid aqueous solution or an alkaline aqueous solution, and then an organic solvent. In addition, an aqueous cleaning solution may be added and the rinsing may be performed in the order of a solution including an acid aqueous solution or an alkaline aqueous solution, an aqueous cleaning solution, and an organic solvent.

The first rinsing step may be performed once or twice or more after the cleaning step or before the surface treatment step. Other steps may be included between the plurality of first rinsing steps or between the first rinsing step and the surface treatment step.

In methods for supplying the cleaning liquid, it is possible to use a known means and examples thereof include a single-wafer system represented by a cleaning method using a spin cleaning device that cleans the wafers one by one by supplying a cleaning liquid near the center of rotation while holding the wafers almost horizontally and rotating and a batch system using a cleaning device that immerses and cleans a plurality of wafers in a cleaning tank. In addition, the cleaning liquid may be supplied using vapor, as in the surface treatment composition described below.

This makes it possible to hold the cleaning liquid in at least the concave portions 4 of the uneven pattern 2 of the wafer 1.

Subsequently, in a state where the cleaning liquid (the liquid 8) is held in at least the concave portions 4 of the uneven pattern 2, the vapor 9 of the surface treatment composition of the present embodiment is supplied to the surface of the uneven pattern, the vapor 9 changes state to become the liquid 10 on the wafer surface, and the liquid 8 held in at least the concave portions 4 is replaced with the liquid 10, which is held to form a water-repellent protective film (the protective film 11) on at least a part of the wafer surface, for example, the surface of the concave portions 4.

When the vapor 9 of the surface treatment composition is supplied, the cleaning liquid (liquid 8) held on the wafer surface may be the above-described aqueous cleaning solution or the first rinsing solution, and, from the viewpoint of production stability, the first rinsing solution is preferable, in which 2-propanol (iPA) may be included. That is, as one aspect of the method for producing a wafer, the vapor 9 of the surface treatment composition may be supplied in a state where iPA is held on the surface of the wafer.

In addition, the method for producing a wafer includes a step of mixing the materials of each component of the surface treatment composition, and the total amount of moisture in the materials may be, for example, 2000 ppm by mass or less with respect to the total amount of the materials, preferably 500 ppm by mass or less, more preferably 100 ppm by mass or less, and even more preferably 50 ppm by mass or less. The smaller the total amount of moisture in the material, the easier it is to obtain a surface treatment composition that easily increases the water contact angle, which is preferable.

Examples of methods for supplying the vapor 9 of the surface treatment composition include a method in which the wafer 1 holding the liquid 8 in at least the concave portions 4 of the uneven pattern 2 is arranged in a chamber and vapor obtained by separately evaporating the surface treatment composition is supplied to the surface of the uneven pattern via piping or a nozzle, and the like. A carrier gas such as nitrogen gas or dry air may be used when supplying the vapor.

It is noted that the method for vaporizing the surface treatment composition is not particularly limited to the above-described method.

Examples thereof include a batch-type vaporization method in which a predetermined amount of a surface treatment composition in a liquid state is introduced into a vaporization chamber, sufficient heating is performed to evaporate the entire amount of the surface treatment composition, and after the entire amount evaporates, the vapor 9 is sent out to piping or a nozzle to be supplied to the surface of the uneven pattern.

In addition, another example is a continuous vaporization method in which droplets of the surface treatment composition are dropped into a small preheated vaporization section (for example, by installing a heating means in a part of the piping) such that the entire amount of the surface treatment composition evaporates with each drop and the vapor 9 is sent out to piping or a nozzle to be supplied to the surface of the uneven pattern.

The vaporization temperature is preferably suppressed to a temperature at which there is no risk of causing thermal decomposition of the silylating agent, which is a protective film forming component.

Examples of preferable vapor treatment conditions include introducing nitrogen gas and supplying the mixed gas to the uneven pattern surface after the composition of the mixed gas of the vapor obtained as described above and the nitrogen gas becomes constant.

The ambient temperature near the substrate during treatment, that is, the temperature of the vapor, is preferably lower than the boiling point of the liquid 8 held in the concave portions 4. When the above is satisfied, it is possible to prevent the liquid 8 held in the concave portions from volatilizing before the surface treatment composition replaces the liquid 8, thus making it easier to suppress pattern collapse of the uneven pattern 2.

Fig. 3 shows a schematic view of a state in which the vapor 9 is supplied to the concave portions 4 holding the liquid 8. Fig. 4 shows a schematic view of the state of the concave portions 4 where the water-repellent protective film 11 is formed using the surface treatment composition. The wafer 1 in the schematic views of Fig. 3 and Fig. 4 shows a part of the a-a' cross-section of Fig. 1.

As shown in Figs. 3 and 4, the supplied vapor 9 changes state to become the liquid 10 in the concave portions 4, the liquid 8 held in the concave portions 4 is replaced with the liquid 10, and the liquid 10 is held in the concave portions 4. In addition, for the purpose of promoting or stabilizing the above state change, the temperature of the wafer 1 and the concave portion 4 may be adjusted by lowering or keeping the temperature constant, or the like.

On the wafer surface, the silylating agent of the liquid 10 reacts with the wafer surface and the above-described site having a water-repellent functional group is fixed to the wafer surface to form a water-repellent protective film (the protective film 11).

The protective film 11 is not necessarily formed continuously or formed uniformly, but is more preferably formed continuously and uniformly since it is possible to provide better water repellency.

By replacing the liquid 8 held on the wafer surface, such as the first rinsing solution or aqueous cleaning solution, using the liquid 10 obtained by liquefying the vapor 9 of the surface treatment composition, it is possible to perform a surface modification treatment, that is, the formation of the protective film 11, before the surface of the uneven pattern 2 on the surface of the wafer 1 dries. This makes it possible to suppress pattern collapse of the uneven pattern 2.

As necessary, the formation of the protective film 11 may be promoted by applying a known means such as a heating treatment, a reduced pressure treatment, or a drying treatment to the liquid 10 held on the wafer surface.

Subsequently, as necessary, the wafer surface on which the protective film 11 is formed may be brought into contact with a second rinsing solution (second rinsing step).

As the second rinsing solution, it is possible to use the solutions described as examples for the first rinsing solution.

In addition, a plurality of types may be used as the second rinsing solution. For example, it is possible to perform the rinsing through contact with water and an organic solvent such as isopropanol, in this order.

The second rinsing step may be performed once or twice or more after the surface treatment step. Other steps may be included between the plurality of second rinsing steps or between the second rinsing step and the surface treatment step.

Subsequently, after forming the protective film 11, a drying step for drying the surface of the wafer 1 may be performed, as necessary.

It is possible to remove the liquid present on the surface of the wafer 1 by the drying step.

The liquid may include the liquid 10, the second rinsing solution, or a mixed liquid thereof.

As a drying means, for example, a known means may be used, such as a spin drying method, iPA (2-propanol) vapor drying, Marangoni drying, heat drying, hot air drying, vacuum drying, and reduced pressure drying.

The drying step may be performed once or twice or more, and may be performed, for example, after the surface treatment step or after the second rinsing step. The drying step and the second rinsing step may be alternately repeated.

Subsequently, the protective film 11 on the surface of the wafer 1 may be removed (removal step).

Examples of removal means include heating, UV irradiation, ozone exposure, plasma irradiation, corona discharge, and the like. In addition, a treatment using a concentrated fluid such as a supercritical fluid (which may include an acid, a base, and an oxidizing agent) or a vapor treatment may be performed. The above may be used alone or in a combination of two or more. These treatments may be performed under atmospheric pressure or reduced pressure.

Through the above, the wafer 1 (semiconductor substrate) using the surface treatment composition of the present embodiment is obtained.

Although the production method shown in Figs. 1 to 4 is for wafer patterns, the present invention is not limited thereto. In the substrate production method of the present embodiment, with the resist pattern as the target, it is also possible to suppress collapse of the resist pattern by using the surface treatment composition of the present invention in the cleaning and drying steps.

Although a production method was explained in which the above-described supply step is carried out after the cleaning step, the supply step is not limited thereto and may be carried out after various treatments carried out on the uneven pattern 2.

In addition to the steps described above, the substrate production method may use one or a combination of two or more known treatments. For example, after the above-described removal step, a surface treatment such as a plasma treatment may be performed.

Although embodiments of the present invention were described above, these are examples of the present invention and it is possible to adopt various configurations other than as described above. In addition, the present invention is not limited to the above-described embodiments, and the present invention includes modifications, improvements, and the like in a range in which it is possible to achieve the purpose of the present invention.

### Examples

Examples that more specifically describe embodiments of the present invention are shown below.

The present invention is not limited only to these Examples.

### [Example 1]

### (Preparation of Surface Treatment Composition)

5 g of trimethylsilyldimethylamine [(CH₃)₃Si-N(CH₃)₂] (referred to below as "TMSDMA") as a silylating agent and 95 g of tert-butylbenzene as a solvent were mixed to obtain a surface treatment composition (referred to below as "composition").

Immediately after being prepared, the composition was evaluated in the manner described below and the results are shown in Table 1.

### (Evaluation of Ease of Increasing Water Contact Angle of Composition (Evaluation of Contact Angle of Water-Repellent Protective Film formed on the Wafer Surface))

Making the surface of a wafer into a surface having an uneven pattern and replacing a cleaning liquid held in at least the concave portions of the uneven pattern with another cleaning liquid are variously studied in other documents and the like and are already established techniques. In the present invention, the effect of imparting water repellency when carrying out surface treatment of a wafer using vapor of the composition was evaluated.

However, in a case of a wafer having an uneven pattern on the surface, it is not possible to accurately evaluate the contact angle of the protective film 11 (water-repellent protective film) itself formed on the surface of the uneven pattern.

To evaluate the contact angle of water droplets, several µl of water droplets are dropped on the surface of the sample (base material) surface and the angle between the water droplets and the base material surface is measured, as in JIS R 3257:1999 "Wettability test method for substrate glass surface". However, in the case of patterned wafers, the contact angle of the water droplets becomes extremely large. This is because the Wenzel effect and Cassie effect occur and the contact angle is influenced by the surface shape (roughness) of the base material, increasing the apparent contact angle of the water droplets.

Therefore, in the present Example, the vapor of the above-described composition was supplied to a wafer having a smooth surface to form a protective film on the wafer surface, this protective film was regarded as a protective film formed on the surface of a wafer having an uneven pattern on the surface, and the following procedure was used for evaluation. In the present Example, a silicon wafer to which a thermal oxide film was attached and which had a SiO₂ layer on a silicon wafer having a smooth surface was used as the wafer having a smooth surface.

### (1) Cleaning of Silicon Wafer

A smooth silicon wafer to which a thermal oxide film was attached (Si wafer having a 1 µm thick thermal oxide film layer on the surface; manufactured by Kyodo International, Inc.) which was 2 cm square in size was immersed in a 1% by mass hydrofluoric acid aqueous solution at 25°C for 10 minutes, immersed at 25°C for 1 minute in pure water, and then immersed at 25°C for 1 minute in 2-propanol (referred to below as "iPA").

### (2) Surface Treatment Using Vapor on Silicon Wafer Surface

After the above-described cleaning, the silicon wafer is arranged horizontally in a vapor treatment chamber in a state of being filled to the brim with iPA and the composition in the solution state prepared as described above was vaporized under the vapor supply conditions described below and the vapor is supplied to the vapor treatment chamber.

The supplied vapor was changed to a liquid state on the wafer surface at a temperature of 50°C or lower and the iPA held on the wafer surface was replaced with the liquid.

Vapor supply conditions for the above-described composition: while nitrogen gas flowed at a rate of 2 dm³/min, the above-described prepared composition in a solution state was dropped at a drop rate of 0.01 g/sec into the vaporization chamber heated to 165°C and the entire drop amount was vaporized. The vapor was immediately supplied to the vapor treatment chamber using the nitrogen gas flow. This treatment was performed for 40 seconds.

### (3) Cleaning of Silicon Wafer

Thereafter, the silicon wafer was taken out of the vapor treatment chamber and immersed in iPA at 25°C for 1 minute. Finally, the silicon wafer was taken out from the iPA and the iPA on the surface was removed by blowing air.

Through the above, a silicon wafer having a protective film formed on the surface was obtained.

### (4) Water Contact Angle Measurement of Protective Film

2 µl of pure water was placed on the surface of the wafer on which the protective film was formed, the angle (water contact angle) between the water droplets and the wafer surface was measured at five points with a contact angle meter (CA-X model, manufactured by Kyowa Interface Science Co., Ltd.) in accordance with JIS R 3257: 1999 "Wettability test method for substrate glass surface", and the average value and standard deviation (variation of water contact angle in the wafer surface) were calculated. The contact angle on the surface of a silicon wafer having no protective film formed on the surface, which was obtained by carrying out the treatments of (1) and (3) without performing (2) described above, was less than 10°.

### [Table 1]

**Table 1**

| | Composition | | | | Boiling point difference between silylating agent and solvent [°C] | Evaluation | |
|---|---|---|---|---|---|---|---|
| | Silylating agent | Solvent | Content of hydrocarbon solvent in solvent [% by mass] | Content of silylating agent in a total amount of composition [% by mass] | | Water contact angle (average value) [°] | Variation in water contact angle (standard deviation) |
| Example 1 | TMSDMA | tert-butylbenzene | 100 | 5 | 101 | 87 | 0.9 |
| Example 2 | TMSDMA | 1,3,5-trimethylbenzene | 100 | 5 | 79 | 87 | 0.5 |
| Example 3 | TMSDMA | 1,2,4-trimethylbenzene | 100 | 5 | 83 | 87 | 0.5 |
| Example 4 | PDMSDMA | 1,2,4-trimethylbenzene | 100 | 5 | | 91 | 0.6 |
| Example 5 | BDMSDMA | 1,2,4-trimethylbenzene | 100 | 5 | | 91 | 0.6 |
| Example 6 | PDMSDMA | 1,2,4-trimethylbenzene | 100 | 3 | | 90 | 0.6 |
| Example 7 | BDMSDMA | 1,2,4-trimethylbenzene | 100 | 10 | | 92 | 0.5 |
| Example 8 | TMSDMA | 1,2,4-trimethylbenzene | 100 | 3 | 83 | 86 | 0.7 |
| Example 9 | TMSDMA | 1,2,4-trimethylbenzene | 100 | 10 | 83 | 88 | 0.6 |
| Example 10 | TMSDMA | tert-butylbenzene | 100 | 3 | 101 | 86 | 0.9 |
| Example 11 | TMSDMA | tert-butylbenzene | 100 | 10 | 101 | 88 | 0.7 |
| Example 12 | TMSDMA | 1,3,5-trimethylbenzene | 100 | 3 | 79 | 86 | 0.5 |
| Example 13 | TMSDMA | 1,3,5-trimethylbenzene | 100 | 10 | 79 | 87 | 0.5 |
| Example 14 | TMSDMA | ethylbenzene | 100 | 5 | 50 | 86 | 0.7 |
| Example 15 | TMSDMA | 1,3-bis(trifluoromethyl)benzene | 100 | 5 | 30 | 86 | 0.6 |
| Example 16 | TMSDMA | 1,4-bis(trifluoromethyl)benzene | 100 | 5 | 31 | 86 | 0.4 |
| Example 17 | TMSDMA | p-xylene | 100 | 5 | 59 | 86 | 0.5 |
| Example 18 | TMSDMA | n-decane | 100 | 5 | 88 | 83 | 5.2 |
| Example 19 | TMSDMA | n-nonane | 100 | 5 | 64 | 85 | 2.3 |
| Example 20 | TMSDMA | isododecane | 100 | 5 | 94 | 85 | 0.6 |
| Example 21 | TMSDMA | ethylcyclohexane | 100 | 5 | 46 | 83 | 0.6 |
| Example 22 | TMSDMA | p-mentane | 100 | 5 | 85 | 83 | 6.5 |
| Example 23 | TMSDMA | pinane | 100 | 5 | 70 | 84 | 2.2 |
| Example 24 | TMSDMA | 1,2,4-trimethylbenzene, isododecane | 100 (60:40) | 10 | 83 | 87 | 0.6 |
| Example 25 | TMSDMA | 1,3,5-trimethylbenzene, isododecane | 100 (60:40) | 10 | 79 | 87 | 0.6 |
| Example 26 | TMSDMA | tert-butylbenzene, isododecane | 100 (60:40) | 10 | 101 | 86 | 0.6 |
| Example 27 | TMSDMA | 1,2,4-trimethylbenzene, PGMEA | 98 | 10 | 83 | 85 | 0.7 |
| Example 28 | TMSDMA | 1,2,4-trimethylbenzene, PGMEA | 80 | 10 | 83 | 82 | |
| Example 29 | TMSDMA | tert-butylbenzene, PGMEA | 98 | 10 | 101 | 84 | 0.7 |
| Example 30 | TMSDMA | tert-butylbenzene, PGMEA | 80 | 10 | 101 | 82 | |
| Example 31 | TMSDMA | heptane | 100 | 10 | 12 | 83 | 0.5 |
| Comparative Example 1 | TMSDMA | diethyl carbonate, propylene carbonate | 0 | 5 | 41 | 80 | |
| Comparative Example 2 | TMSDMA | 1,2,4-trimethylbenzene, PGMEA | 70 | 5 | 83 | 80 | |

### [Example 2 to Example 31 and Comparative Example 1 to Comparative Example 2]

Each of the compositions was prepared in the same manner as in Example 1, except that the solvents listed in Table 1 were used as the solvent, various evaluations were performed, and the results are shown in Table 1. In Table 1, the value of the boiling point difference between the silylating agent and the solvent is calculated using known reference values or catalog values and "-" indicates that the value is not calculated due to the absence of a reference value or the like. In addition, "-" in the water contact angle variation indicates that measurement was not carried out.

The solvent in Example 24 is a mixed solvent of 60% by mass of 1,2,4-trimethylbenzene and 40% by mass of isododecane in the total amount of the solvent, the solvent in Example 25 is a mixed solvent of 60% by mass of 1,3,5-trimethylbenzene and 40% by mass of isododecane, the solvent in Example 26 is a mixed solvent of 60% by mass of tert-butylbenzene and 40% by mass of isododecane, the solvent in Example 27 is a mixed solvent of 98% by mass of 1,2,4-trimethylbenzene and 2% by mass of propylene glycol monoethyl ether acetate (PGMEA), the solvent in Example 28 is a mixed solvent of 80% by mass of 1,2,4-trimethylbenzene and 20% by mass of PGMEA, the solvent in Example 29 is a mixed solvent of 98% by mass of tert-butylbenzene and 2% by mass of PGMEA, and the solvent in Example 30 is a mixed solvent of 80% by mass of tert-butylbenzene and 20% by mass of PGMEA. In addition, the solvent of Comparative Example 1 is a mixed solvent of 47% by mass of propylene carbonate and 53% by mass of diethyl carbonate in the total amount of the solvent and the solvent of Comparative Example 2 is a mixed solvent of 70% by mass of 1,2,4-trimethylbenzene and 30% by mass of PGMEA in the total amount of the solvent.

In addition, the silylating agent in Example 4 and Example 6 is propyldimethylsilyldimethylamine [PDMSDMA:
(CH₃CH₂CH₂)(CH₃)₂Si-N(CH₃)₂] and the silylating agent in Example 5 and Example 6 is butyldimethylsilyldimethylamine [BDMSDMA: (CH₃CH₂CH₂CH₂)(CH₃)₂Si-N(CH₃)₂].

Since the water contact angles (average values) of the surface treatment compositions of Examples 1 to 31 are larger than the angles of Comparative Examples 1 to 2, the surface treatment composition of the present invention may be said to easily increase the water contact angle in comparison with the related art.

In addition, among the above-described Examples, when 1,2,4-trimethylbenzene, 1,3,5-trimethylbenzene, tert-butylbenzene, ethylbenzene, 1,3-bis(trifluoromethyl)benzene, 1,4-bis(trifluoromethyl)benzene, p-xylene, n-nonane, or isododecane was used as the solvent, the result was that the water contact angle was more easily increased.

In addition, among the above-described examples, when 1,2,4-trimethylbenzene, 1,3,5-trimethylbenzene, tert-butylbenzene, ethylbenzene, 1,3-bis(trifluoromethyl)benzene, 1,4-bis(trifluoromethyl)benzene, or p-xylene was used as the solvent, the result was that a higher water contact angle was obtained and the standard deviation was also less than 2.0 for variations in the water contact angle.

Priority is claimed based on Japanese Patent Application No. 2022-065098 filed April 11, 2022 and Japanese Patent Application No. 2022-128657 filed August 12, 2022, the entire disclosure of which is incorporated herein.

### REFERENCE SIGNS LIST

1 Wafer
2 Uneven pattern
3 Convex portion
4 Concave portion
5 Width of concave portion
6 Height of convex portion
7 Width of convex portion
8 Liquid
9 Vapor
10 Liquid
11 Protective film

## Claims

1. A surface treatment composition which is supplied as vapor to a surface of a wafer having an uneven pattern on the surface and is used for forming a water-repellent protective film on the surface, the surface treatment composition comprising:
a silylating agent; and
a solvent,
wherein the silylating agent includes a silicon compound represented by Formula (1),
(R¹)₃Si-X (1)
(R¹'s are each independently a group selected from the group consisting of a hydrocarbon group having 1 to 10 carbon atoms and a hydrocarbon group having 1 to 10 carbon atoms in which some or all hydrogen atoms are substituted with fluorine atoms, and X is an amino group), and
wherein the solvent includes 75% by mass or more of a hydrocarbon solvent in 100% by mass of a total amount of the solvent.

2. The surface treatment composition according to Claim 1,
wherein a content of the hydrocarbon solvent is 97% by mass or more in 100% by mass of the total amount of the solvent.

3. The surface treatment composition according to Claim 1 or 2,
wherein the hydrocarbon solvent includes an aromatic hydrocarbon.

4. The surface treatment composition according to any of Claims 1 to 3,
wherein a content of the silylating agent in 100% by mass of the surface treatment composition is 0.3% by mass or more and 30% by mass or less.

5. The surface treatment composition according to any of Claims 1 to 4,
wherein a boiling point difference between a boiling point of the solvent and a boiling point of the silylating agent (boiling point of the solvent - boiling point of the silylating agent) at 1 atm is 20°C or more.

6. The surface treatment composition according to any of Claims 1 to 5,
wherein the silicon compound includes one or two or more selected from the group consisting of trimethylsilyldimethylamine, trimethylsilyldiethylamine, N-(trimethylsilyl)-tert-butylamine, hexamethyldisilazane, and compounds in which at least one trimethylsilyl group of these trimethylsilylamines is substituted with any of an ethyldimethylsilyl group, a propyldimethylsilyl group, a butyldimethylsilyl group, a hexyldimethylsilyl group, an octyldimethylsilyl group, and a decyldimethylsilyl group.

7. The surface treatment composition according to any of Claims 1 to 6,
wherein a water contact angle on a surface of a silicon wafer after surface treatment is greater than 80°, as measured by a procedure as below,
(procedure)
a smooth silicon wafer having a thermal oxide film layer on a surface is immersed in a 1% by mass hydrofluoric acid aqueous solution at 25°C for 10 minutes and immersed and cleaned in pure water at 25°C for 1 minute and 2-propanol (iPA) at 25°C for 1 minute,
after cleaning, the silicon wafer is arranged horizontally in a state of being filled to the brim with iPA and the vapor of the surface treatment composition is supplied to the silicon wafer,
subsequently, on the surface of the silicon wafer, the vapor is changed into a liquid state and the iPA held on the surface is replaced with the liquid,
subsequently, the silicon wafer is immersed in iPA at 25°C for 1 minute,
thereafter, air is blown onto the silicon wafer to remove the iPA on the surface, and
with respect to the silicon wafer surface obtained through the above steps, the water contact angle described above is measured in accordance with "Wettability test method for substrate glass surface" of JIS R 3257:1999 using 2 µl of pure water.

8. The surface treatment composition according to any of Claims 1 to 7,
wherein the surface treatment composition does not include a non-cyclic carbonate ester or includes 2% by mass or less of a non-cyclic carbonate ester in 100% by mass of the surface treatment composition.

9. The surface treatment composition according to any of Claims 1 to 8,
wherein the surface treatment composition does not include a catalyst or includes a catalyst in a content of 2% by mass or less in 100% by mass of the surface treatment composition.

10. The surface treatment composition according to any of Claims 1 to 9,
wherein a number of particles larger than 0.2 µm measured using a light-scattering particle-in-liquid detector is 1.0 × 10⁴ or less per 1 mL of the surface treatment composition.

11. The surface treatment composition according to any of Claims 1 to 10,
wherein a total content of Na, Mg, Ca, Mn, Fe, Cu, Li, Al, Cr, Ni, Zn, and Ag measured using inductively coupled plasma mass spectrometry is 100 mass ppb or less in the surface treatment composition.

12. A method for producing a wafer comprising:
a step of preparing a wafer having an uneven pattern on a surface;
a step of supplying a cleaning liquid to the surface of the wafer to carry out cleaning; and
a step of supplying vapor of a surface treatment composition to the surface holding the cleaning liquid, changing the state of the vapor to a liquid on the surface, replacing the cleaning liquid with the liquid, and forming a water-repellent protective film on at least a part of the surface,
wherein the surface treatment composition includes a silylating agent, and a solvent,
wherein the silylating agent includes a silicon compound represented by Formula (1),
(R¹) ₃Si-X (1)
(R¹'s are each independently a group selected from the group consisting of a hydrocarbon group having 1 to 10 carbon atoms and a hydrocarbon group having 1 to 10 carbon atoms in which some or all hydrogen atoms are substituted with fluorine atoms, and X is an amino group), and
wherein the solvent includes 75% by mass or more of a hydrocarbon solvent in 100% by mass of a total amount of the solvent.

13. The method for producing a wafer according to Claim 12,
wherein a content of the hydrocarbon solvent is 97% by mass or more in 100% by mass of the total amount of the solvent.

14. The method for producing a wafer according to Claim 12 or 13,
wherein, in the surface treatment composition, the hydrocarbon solvent includes an aromatic hydrocarbon.

15. The method for producing a wafer according to any of Claims 12 to 14,
wherein, in the surface treatment composition, a content of the silylating agent is 0.3% by mass or more and 30% by mass or less in 100% by mass of the surface treatment composition.

16. The method for producing a wafer according to any of Claims 12 to 15,
wherein, in the surface treatment composition, a boiling point difference between a boiling point of the solvent and a boiling point of the silylating agent (boiling point of the solvent - boiling point of the silylating agent) at 1 atm is 20°C or more.

17. The method for producing a wafer according to any of Claims 12 to 16,
wherein, in the surface treatment composition, the silicon compound includes one or two or more selected from the group consisting of trimethylsilyldimethylamine, trimethylsilyldiethylamine, N-(trimethylsilyl)-tert-butylamine, hexamethyldisilazane, and compounds in which at least one trimethylsilyl group of these trimethylsilylamines is substituted with any of an ethyldimethylsilyl group, a propyldimethylsilyl group, a butyldimethylsilyl group, a hexyldimethylsilyl group, an octyldimethylsilyl group, and a decyldimethylsilyl group.

18. The method for producing a wafer according to any of Claims 12 to 17,
wherein the surface treatment composition does not include a non-cyclic carbonate ester or includes 2% by mass or less of a non-cyclic carbonate ester in 100% by mass of the surface treatment composition.

19. The method for producing a wafer according to any of Claims 12 to 18,
wherein the surface treatment composition does not include a catalyst or includes a catalyst in a content of 2% by mass or less in 100% by mass of the surface treatment composition.

20. The method for producing a wafer according to any of Claims 12 to 19,
wherein, in the surface treatment composition, a number of particles larger than 0.2 µm measured using a light-scattering particle-in-liquid detector is 1.0 × 10⁴ or less per 1 mL of the surface treatment composition.

21. The method for producing a wafer according to any of Claims 12 to 20,
wherein, in the surface treatment composition, a total content of Na, Mg, Ca, Mn, Fe, Cu, Li, Al, Cr, Ni, Zn, and Ag measured using inductively coupled plasma mass spectrometry is 100 mass ppb or less in the surface treatment composition.

22. The method for producing a wafer according to any of Claims 12 to 21,
wherein the vapor of the surface treatment composition is supplied in a state where iPA is held on the surface of the wafer.

23. The method for producing a wafer according to any of Claims 12 to 22, further comprising:
a step of mixing materials of each component of the surface treatment composition,
wherein a total amount of moisture in the materials is 2000 ppm by mass or less with respect to a total amount of the materials.
